# EUROPÄISCHE PATENTSCHRIFT

(11) **EP 0 873 534 B1**
(45) Veröffentlichungstag und Bekanntmachung des Hinweises auf die Patenterteilung: **09.04.2003**
(21) Anmeldenummer: 97904990.5
(22) Anmeldetag: 08.01.1997
(51) Int. Cl.: G02B 6/42

(54) **OPTOELEKTRONISCHE SENDEBAUGRUPPE**
ELECTRO-OPTICAL TRANSMISSION ASSEMBLY
BLOC DE COMPOSANTS D'EMISSION OPTOELECTRONIQUES

(30) Priorität: 09.01.1996 DE 19601955
(43) Veröffentlichungstag der Anmeldung: 28.10.1998
(73) Patentinhaber: Infineon Technologies AG, 81669 München (DE)
(72) Erfinder: KROPP, Jörg-Reinhardt, D-12355 Berlin (DE)
(74) Vertreter: Müller, Wolfram Hubertus, Dipl.-Phys.
(86) Internationale Anmeldenummer: DE9700052
(87) Internationale Veröffentlichungsnummer: WO97025641

(56) Entgegenhaltungen:
- FR-A- 2 536 546
- GB-A- 2 276 493
- US-A- 4 732 446
- US-A- 5 282 080
- PATENT ABSTRACTS OF JAPAN vol. 003, no. 009 (E-086), 26.Januar 1979 & JP 53 135652 A (FUJITSU LTD), 27.November 1978,

## Beschreibung

Die Erfindung betrifft eine optoelektronische Sendebaugruppe mit mindestens einem Sendeelement nach dem Oberbegriff des Patentanspruchs 1.

Optoelektronische Sendebaugruppen mit aktiven Bauelementen, insbesondere Halbleiterlasern, weisen häufig eine Rückkopplungs-Schaltung zur Regelung des temperatur- und alterungsabhängigen Treiberstroms für den Halbleiterlaser auf. Ein Teil der vom Laser emittierten Strahlung wird von einer als Monitordiode dienenden Fotodiode detektiert, wobei der Diodenstrom als Regelsignal für die Rückkopplungs-Schaltung zur Verfügung steht. Schwankungen der Intensität der emittierten Strahlung können somit ausgeregelt werden.

Eine Sendebaugruppe für Halbleiterlaser ist in der GB-A-2 276 493 beschrieben. Auf einem Siliziumträger sind Monitordiode, Halbleiterlaser und ein Linsensystem in Reihe angeordnet, wobei die optischen Achsen der drei Baugruppen zueinander koaxial ausgerichtet sind und parallel zur Siliziumträgeroberfläche verlaufen. Der Halbleiterlaser weist zwei Emissionsrichtungen auf. Eine Hauptemissionsrichtung ist dem Linsensystem zugewandt. In eine entgegengesetzte Richtung hingegen wird ein geringerer Teil emittiert, der von der Monitordiode zur Regelung des Treiberstroms detektiert wird. Die vorbekannte optische Sendebaugruppe erfordert zwei Emissionsrichtungen und eine genaue Justage der einzelnen Baugruppen zueinander.

Eine optische Sendebaugruppe der eingangs genannten Art ist der US-Patentschrift 4,733,094 zu entnehmen. Die bekannte Sendebaugruppe ist in einem Transistorgehäuse untergebracht und weist unter anderem eine Stützplatte auf, die auf einem Bodenteil des Transistorgehäuses ruht. Auf der Stützplatte befindet sich eine Basisplatte, auf der nebeneinander ein Sendeelement in Form einer Lumineszenzdiode und eine Photodiode angeordnet sind. Oberhalb des Sendeelementes in Strahlenrichtung befindet sich ein halbdurchlässiger Spiegel, dem in Strahlenrichtung ein Koppelelement in Form einer Mikrolinse nachgeordnet ist; die Mikrolinse ist im oberen Teil eines topfartigen Deckels des Transistorgehäuses gehalten. Von dem halbdurchlässigen Spiegel wird ein Teil des von dem Sendeelement abgegebenen Lichtes zu einem weiteren Spiegel reflektiert und von diesem auf die Photodiode gelenkt.

Der vorliegenden Erfindung liegt die Aufgabe zugrunde, eine vergleichsweise einfache und kompakte Sendebaugruppe zu schaffen.

Erfindungsgemäß wird diese Aufgabe mit einer optischen Sendebaugruppe mit den Merkmalen des Patentanspruch 1 gelöst.

Ein wesentlicher Vorteil der erfindungsgemäßen Sendebaugruppe besteht in ihrer einfachen Ausführung mit einem einteiligen Grundkörper, der das reflektierende Element und das Koppelelement aufweist; dadurch ist auch die Fertigung vergleichsweise einfach durchführbar und damit auch kostengünstig. Ein weiterer wesentlicher Vorteil besteht in der relativ einfach durchführbaren Justierung, weil bei der erfindungsgemäßen Sendebaugruppe das reflektierende Element und das Koppelelement eine vorgegebene Position aufweisen und daher nur noch eine Justierung des Grundkörpers zu Monitor- und Sendeelement erfolgen muß.

Bei einer erfindungsgemäßen Sendebaugruppe, bei der die aktive Oberfläche mehrere Laser aufweist, kann die Strahlung eines Lasers zur Regelung des Treiberstroms aller Laser ausgenutzt werden. Die Oberfläche kann dabei in mehrere aktive Bereiche unterteilt sein oder durch Zusammenfassen von mehreren diskreten Einzellasern gebildet werden. Wenigstens gegenüber einem Abschnitt der aktiven Oberfläche auf einer einzigen Bauteilseite - der Abschnitt kann dabei einen oder mehrere emittierende Bereiche oder Einzellaser umfassen - ist ein reflektierendes Element und ein Koppelelement angeordnet.

In vorteilhafter Weise besteht bei einer weiteren Ausgestaltung der Erfindung der Grundkörper aus einem im charakteristischen Emissionswellenlängenbereich des Sendeelements transparenten Material. Bekannte planare Strukturierungstechniken können in vorteilhafter Weise zur Integration des Koppelelements und des reflektierenden Elements herangezogen werden. Die Justage der Kopplungsvorrichtung kann bei aktivem oder inaktivem Sendeelement erfolgen. Beide Justagemöglichkeiten dienen der gewünschten Lageausrichtung der Kopplungsvorrichtung und dem Festlegen des Regelsignals.

Das Koppelelement kann als diffraktives und/oder refraktives Element ausgelegt sein. Besonders vorteilhaft ist die Verwendung einer Linse bzw. eines Linsensystems oder einer Zonenplatte, die auf der dem Sende- und Monitorelement abgewandten Seite der Kopplungseinheit aufgebracht ist. Es ist auch die Verwendung einer integrierten Gradientenindexlinse denkbar. Eine Anordnung auf der den elektronischen Bauelementen unmittelbar zugewandten Seite ist ebenfalls möglich.

Hochpräzise Strukturierungstechniken können auch für die Montage von Sendeelement und Monitorelement auf einem gemeinsamen Träger angewendet werden. Durch den gewählten Aufbau ist auch eine monolithische Integration von Sende- und Monitorelement auf einem Halbleiter-Chip möglich.

Eine weitere vorteilhafte Ausfuhrungsform sieht vor, daß wenigstens ein Teil der von dem Abschnitt emittierten Strahlung durch Reflexion am reflektierenden Element auf das Monitorelement gelenkt wird und ein anderer Teil der Strahlung am Koppelelement reflektiert wird. Das Koppelelement ist vorteilhaft an der dem Sendeelement zugewandten Seite der Kopplungsvorrichtung angeordnet. Beispielsweise mittels eines Hohlspiegels wird die Strahlung von dem Koppelelement in einen Lichtwellenleiter eingekoppelt.

Eine besondere Ausgestaltung des reflektierenden Elements wird durch wenigstens einen verspiegelten Bereich der Kopplungsvorrichtung erreicht. Vorteilhaft ist die Anordnung einer verspiegelten Flache unmittelbar neben einer Linse auf der sendeelementabgewandten Seite der Kopplungsvorrichtung.

Ebenso sind reflektierende Flächen, deren Flächenausrichtung unter einem Winkel zur Oberfläche der Kopplungsvorrichtung geneigt sind, zur Umlenkung geeignet. Zur Erhöhung des Reflexionsgrades sind diese Vertiefungen ebenfalls metallisiert oder weisen eine andere reflexionsverstärkende Beschichtung, z. B. einen dielektrischen Überzug, auf.

Andere vorteilhafte Ausführungsformen weisen wenigstens bereichsweise verspiegelte Vertiefungen in der Kopplungsvorrichtung auf, die die Punktion des reflektierenden Elements übernehmen. Beispielsweise hohlspiegelartig geformte Vertiefungen können zur Umlenkung eines Teils der Strahlung auf das Monitorelement verwendet werden.

Bevorzugt werden für die Kopplungsvorrichtung kristalline Materialien sowie Glasarten verwendet. Sofern kristalline Materialien gewählt werden, werden die Vertiefungen vorzugsweise durch anisotropes Atzen gebildet. Bei anderen nichtkristallinen Materialien kommen isotrope Ätztechniken und Prägen zur Anwendung. Besonders geeignete kristalline Materialien sind Silizium und Galliumphosphid.

Zur Beabstandung und optischen Ausrichtung können Distanzstücke zwischen einem sende- und monitorelementunterstutzenden Trager und der Kopplungsvorrichtung eingesetzt werden. Zur Vermeidung störender, auf das Emissionssignal rückkoppelnder Reflexionen an der Kopplungsvorrichtung und dem Koppelelement werden diese mit reflektionsunterdrückenden Beschichtungen versehen. Besondere Bedeutung kommt derartigen Beschichtungen bei Materialien mit hohem Brechungsindex, beispielsweise Silizium, zu. Rückkopplungen können aber auch durch ein geeignetes Verkippen der Kopplungsvorrichtung gegenüber dem Sendeelement vermieden werden. Eventuell reflektierte Strahlung gelangt durch die Verkippung nicht mehr auf die aktive Oberfläche des Sendeelements.

Unter Anwendung bekannter Verbindungscechniken wie Löten und Kleben wird aus der Kopplungsvorrichtung und den elektronischen Bauelementen eine kompakte und dauerhafte Sendebaugruppe gebildet. Materialien, die ein gleiches thermisches Verhalten aufweisen, sind zu bevorzugen.

Zur Erhöhung des Integrationsgrades werden in einer weiteren bevorzugten Ausführungsform Sende- und Monitorelement unmittelbar von der Kopplungsvorrichtung getragen. Die Montage erfolgt bevorzugt mit der Flip-Chip-Technik unter Verwendung von Bumps zur Kontaktierung, wobei der Effekt der Selbstzentrierung zusätzlich ausgenutzt werden kann. Dazu sind auf den zueinanderweisenden Oberflächen von Sende- und Monitorelement einerseits und Kopplungsvorrichtung andererseits Lötflächen vorgesehen, die Lötkügelchen (Bumps) tragen, welche durch Warmeeinwirkung zum Schmelzen gebrächt werden. Dadurch werden Sende- und Monitorelement mit der Kopplungsvorrichtung verbunden und ausgerichtet. Diese Ausführungsform ist durch eine hervorragende mechanische und optische Stabilität gekennzeichnet und kann kostengünstig hergestellt werden.

Entsprechend der bevorzugten Ausführungsformen sind elektrische Kontaktmöglichkeiten entweder trägerseitig oder kopplungsvorrichtungsseitig vorhanden. Vorzugsweise werden bondbare Goldbahnen auf einen Silizium- oder Glasträger verwendet.

Eine Weiterbildung der Erfindung zeichnet sich durch eine von strahlungsaktiven Sendebereichen gebildete aktive Oberfläche des Sendeelements aus, wobei die Bereiche in einer Reihe oder in einer Fläche angeordnet sind. Bei kostengünstigen Ausführungsformen wird der Treiberstrom mehrerer Sendebereiche duch ein Monitorelement geregelt, welches die emittierte Strahlung eines Sendebereichs empfangt. Für die individuelle Regelung jedes Sendebereichs hingegen wird jeweils ein zugehörigen Monitorelement benötigt. Ein oder mehrere reflektierende Elemente reflektiert einen Teil der von dem jeweiligen Sendebereich emittierte Strahlung auf das entsprechende Monitorelement. Die Ausgestaltung der reflektierenden Elemente und der Koppelelemente kann entsprechend den verwendeten Materialien erfolgen.

Nachfolgend wird die Erfindung anhand von Ausführungsbeispielen detailliert beschrieben und in Figuren dargestellt; es zeigen:
Figur 1 eine erfindungsgemäße Sendebaugruppe mit Einzellaser sowie Linse und Spiegel auf gleicher Bauteilseite, und
Figur 2 eine erfindungsgemäße Sendebaugruppe für mehrere Laser mit einer Kopplungsvorrichtung aus Glas.

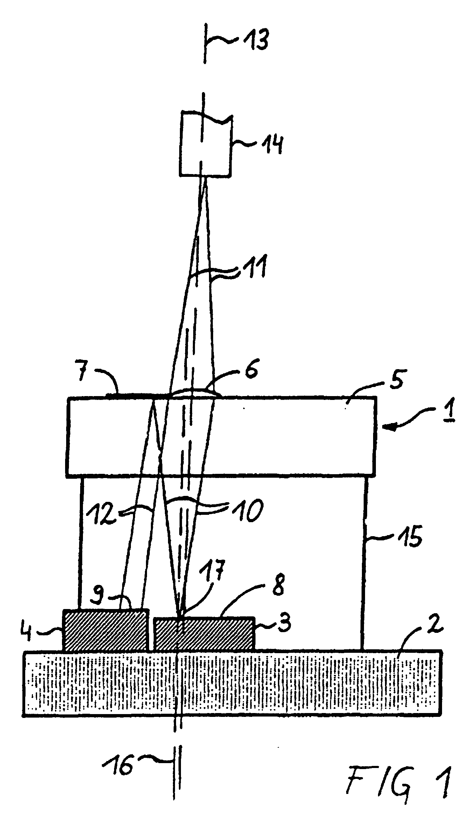

Figur 1 verdeutlicht den prinzipiellen Aufbau einer erfindungsgemäßen Sendebaugruppe. Auf einem Tragermaterial 2 sind ein Sendeelement 3 und ein Monitorelement 4 aufgebracht, wobei die aktive Fläche 8 des Sendeelements 3 und die lichtempfindliche Fläche 9 des Monitorelements 4 vom Träger 2 wegweisen. Den beiden elektronischen Bauelementen 3, 4 gegenüber ist durch ein Distanzstück 15 beabstandet eine Kopplungsvorrichtung 1 angeordnet. Die Kopplungsvorrichtung 1 besteht aus einem Grundkörper 5, der in dem charakteristischen Emissionswellenlängenbereich des Sendeelements 3 eine hohe Transmission aufweist. An der den elektronischen Bauelementen 3, 4 abgewandten Bauteilseite der Kopplungsvorrichtung 1 befinden sich auf dem Grundkörper 5 eine Linse 6 und ein die Linse 6 seitlich begrenzender metallisierter Bereich 7. Die Anordnung der Kopplungsvorrichtung 1 mit den darauf befindlichen optischen Elementen 6, 7 ist so gewählt, daß die von wenigstens einem Abschnitt 17 der aktiven Oberfläche 8 emittierte Strahlung 10 auf die Linse 6 und den metallisierten Bereich 7 gelangt und in einen reflektierten Strahlungsanteil 12 und in einen Nutzanteil 11 zerlegt wird. Der reflektierte Strahlungsanteil 12 wird durch den metallisierten. Bereich 7 auf die lichtempfindliche Fläche 9, des Monitorelements 4 reflektiert. Der Fotostrom des Monitorelements wird zur Regelung des Treiberstroms des Sendeelements verwendet. Die zur Regelung erforderliche Elektronik wurde nicht dargestellt. Zur Anwendung gelangt eine Regelelektronik, die dem jeweiligen Sendeelement 3 angepaßt ist.

Durch seitlichen Versatz der Mittenachse 16 des emittierenden Abschnitts 17 zur optischen Achse 13 der Linse 6 wird gewährleistet, daß ein Teil der emittierten Strahlung 10 auf den metallisierten Bereich 7 fällt und reflektiert wird. Die Justage der Kopplungsvorrichtung 1 erfolgt wahlweise bei aktivem oder inaktivem Sendeelement und gestattet in einem Arbeitsgang die Ausrichtung der Baugruppen zueinander und die Festlegung des Regelsignals in Abhängigkeit von der Größe des reflektierten Strahlungsanteils 12. Nachfolgend wird die Kopplungsvorrichtung 1 mit dem Distanzstück 15 und dem Träger 2 durch Kleben oder Löten fest verbunden,

In der vorliegenden Ausführungsform durchdringt die vom Sendeelement 3 emittierte Strahlung 10 vollständig den Grundkörper 5 der Kopplungsvorrichtung 1 bevor die Aufspaltung in reflektierten Strahlungsanteil 12 und Nutzanteil 11 an der Oberseite des Grundkörpers 5 erfolgt. Schematisch ist ein Lichtwellenleiterende 14 der Linse 6 gegenüber beabstandet dargestellt, um die Einkopplung des Nutzanteils 11 zu verdeutlichen. Die Linse 6, die stellvertretend für eine Abbildungsoptik steht, kann auch den Nutzanteil 11 kollimieren und somit ein schwach divergentes Strahlenbündel erzeugen,

Fertigungstechnisch ist die Lage des Sendeelements 3, des Monitorelements 4 und der Kopplungsvorrichtung 1 beliebig variierbar, um eine gewünschte Gestaltungsform zu erzielen. Wesentlich dabei ist, daß ein Teil der emittierten Strahlung 10 auf das Monitorelement 4 gelangt. Der Abstand der elektronischen Bauelemente 3, 4 und der optischen Bauelemente 6, 7 zueinander kann durch Distanzstücke 15 bestimmt werden. Der hiermit gaschaffene Freistrahlbereich kann zur bedarfsweisen Integration weiterer Bauelemente verwendet werden. Die Größe des Freistrahlbereichs hängt wesentlich von der Abbildungsoptik ab. Der Abstrahlungsgeometrie des Sendeelements 3 soll der Durchmesser und der Öffnungswinkel der Abbildungsoptik angepaßt sein.

Vorteilhaft werden oberflächenemittierende Elemente, wie z. B. vertical cavity surface emitting laser (VCSEL), als Sendeelement 3 benutzt. Für das Monitorelement 4 sind Fotodioden geeignet.

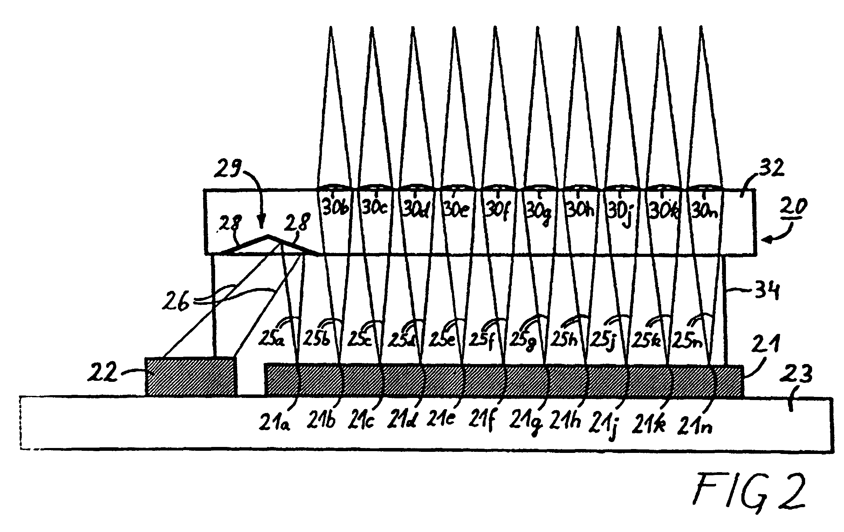

In Figur 2 ist eine Erweiterung des erfindungsgemäßen Gedankens auf eine Reihe von Laserdioden dargestellt. Bei dieser Ausführungsform ist auf einem Träger 23 ein Laserdiodenarray 21, vorzugsweise mit einer Vielzahl von VCSEL-Dioden 21a bis 21n, aufgebracht und seitlich neben dem Array 21 eine Monitordiode 22 angeordnet. Beanstandet durch ein Distanzstück 34 ist die Kopplungsvorrichtung 20 dem Array 21 und der Monitordiode 22 gegenüber fixiert. Auf dem Grumikörper 32 der Kopplungsvorrichtung 20 befinden sich eine Vielzahl von Linsen 30b bis 30n mit gleicher Periodizität wie die VCSEL-Dioden 21b bis 21n. Je einer Laserdiode ist eine Linse zugeordnet. Die von den Laserdioden 21b bis 21n emittierte Strahlung 25b bis 25n wird durch jeweils eine Linse 30b bis 30n kollimiert bzw. fokussiert. Damit lassen sich eine Vielzahl von parallel angeordneten VCSEL-Dioden gleichzeitig in Lichtwellenleiter einkoppeln. Die Laserdioden sind monolithisch auf einem Halbleiter-Chip integriert.

Der Treiberstrom aller Laserdioden 21a bis 21n wird in der vorliegenden Ausführungsform durch die Intensität der Emission einer Laserdiode 21a, geregelt. Deren emittierte Strahlung 25a wird von einer sich auf der Unterseite des Grundkörpers 32 befindliche Vertiefung 29 auf die Monitordiode 22 reflektiert. Die Vertiefung 29 hat einen prismenförmigen Querschnitt mit um 20° zur Unterseite des Grundkörpers 32 geneigten Seitenwänden 28. Zur Erhöhung der Reflexion sind diese mit einem spiegelnden Überzug versehen. Die Strahlung 25a wird an einer der Vertiefungswände 28 reflektiert. Durch deren geneigte Lage wird die Strahlung 25a seitlich weiter als in der Ausführungsform der Figur 1 ausgelenkt. Die Monitordiode 22 kann daher auch von der Laserdiode 21a weiter beabstandet angeordnet sein.

Der Grundkörper 32 besteht aus einem geeigneten Glasmaterial. Vorzugsweise durch Prägen wird die Vertiefung 29 in den Grundkörper 32 eingearbeitet und nachfolgend verspiegelt. Die Linsen 30b bis 30n sind durch einen geeigneten optischen Kleber am Grundkörper 32 befestigt oder können ebenfalls durch Prägen der Glasoberfläche erzeugt werden.

## Patentansprüche

1. Optoelektronische Sendebaugruppe mit mindestens einem Sendeelement (3), mindestens einem Monitorelement (4) und einer Kopplungsvorrichtung (1), welche mindestens ein optisches Koppelelement (6) und mindestens ein reflektierendes Element (7) aufweist, wobei einer strahlungsempfindlichen Oberfläche (9) des Monitorelements (4) und einem auf einer einzigen Bauteilseite des Sendeelements (3) befindlichen Abschnitt (17) einer aktiven Oberfläche (8) des Sendeelements (3) gegenüber sowohl das reflektierende Element (7) als auch das Koppelelement (6) der Kopplungsvorrichtung (1) angeordnet sind,
**dadurch gekennzeichnet, daß**
die Kopplungsvorrichtung (1) ein einteiliger Grundkörper (5) ist, an dem das Koppelelement (6) und das reflektierende Element (7) unmittelbar ausgebildet sind, wobei das Sendeelement (3), das Koppelelement (6) und das reflektierende Element (7) derart zueinander angeordnet sind, daß zumindest ein Teil des vom Sendeelement (3) ausgesandten Lichts auf das Koppelelement (6) und das reflektierende Element (7) trifft.

2. Optoelektronische Sendebaugruppe nach Anspruch 1,
**dadurch gekennzeichnet, daß**
der Grundkörper (5) aus einem im charakteristischen Emissionswellenlängenbereich des Sendeelements (3) transparenten Material besteht.

3. Optoelektronische Sendebaugruppe nach Anspruch 1 oder 2,
**dadurch gekennzeichnet, daß**
wenigstens ein Teil (12) der vom Abschnitt (17) emittierten Strahlung (10) durch Reflexion am reflektierenden Element (7) auf das Monitorelement (4) gelenkt wird, und ein weiterer Teil (11) der Strahlung (10) durch das Koppelelement (6) dringt.

4. Optoelektronische Sendebaugruppe nach einem der vorangehenden Ansprüche,
**dadurch gekennzeichnet, daß**
das reflektierende Element (7) durch wenigstens einen verspiegelten Bereich der Kopplungsvorrichtung (1) gebildet ist.

5. Optoelektronische Sendebaugruppe nach einem der vorangehenden Ansprüche,
**dadurch gekennzeichnet, daß**
wenigstens eine bereichsweise verspiegelte Vertiefung (29) in der Kopplungsvorrichtung (20) als reflektierendes Element dient.

6. Optoelektronische Sendebaugruppe nach einem der vorangehenden Ansprüche,
**dadurch gekennzeichnet, daß**
die Kopplungsvorrichtung (20) aus kristallinem Material oder Glas besteht.

7. Optoelektronische Sendebaugruppe nach einem der vorangehenden Ansprüche,
**dadurch gekennzeichnet, daß**
die Kopplungsvorrichtung das Sendeelement und das Monitorelement trägt.

8. Optoelektronische Sendebaugruppe nach einem der vorangehenden Ansprüche,
**dadurch gekennzeichnet, daß**
in einer Reihe oder in einer Fläche angeordnete strahlungsaktive Sendebereiche (21a-21n) die aktive Oberfläche des Sendeelements (21) bilden.

## Claims

1. Optoelectronic transmit module having at least one transmit element (3), at least one monitor element (4) and one coupling device (1) which has at least one optical coupling element (6) and at least one reflective element (7), both the reflective element (7) and the coupling element (6) of the coupling device (1) being arranged opposite a radiation-sensitive surface (9) of the monitor element (4) and a section (17) of an active surface (8) of the transmit element (3), said section (17) being located on a single side of a component of the transmit element (3), **characterized in that** the coupling device (1) is a single-component base body (5) on which the coupling element (6) and the reflective element (7) are directly formed the transmit element (3), the coupling element (6) and the reflective element (7) being arranged with respect to one another in such a way that at least a portion of the light emittal by the transmit element (3) is incident on the coupling element (6) and the reflective element (7).

2. Optoelectronic transmit module according to Claim 1, **characterized in that** the base body (5) is composed of a material which is transparent in the characteristic emissions wavelength range of the transmit element (3).

3. Optoelectronic transmit module according to Claim 1 or 2, **characterized in that** at least part (12) of the radiation (10) emitted by the section (17) is directed onto the monitor element (4) by reflection at the reflective element (7), and a further part (11) of the radiation (10) penetrates the coupling element (6).

4. Optoelectronic transmit module according to one of the preceding claims, **characterized in that** the reflective element (7) is formed by means of at least one mirrored region of the coupling device (1).

5. Optoelectronic transmit module according to one of the preceding claims, **characterized in that** at least one depression (29), mirrored in certain regions, in the coupling device (20) serves as a reflective element.

6. Optoelectronic transmit module according to one of the preceding claims, **characterized in that** the coupling device (40) is composed of crystalline material or glass.

7. Optoelectronic transmit module according to one of the preceding claims, **characterized in that** the coupling device is fitted with the transmit element and the monitor element.

8. Optoelectronic transmit module according to one of the preceding claims, **characterized in that** radiation-active transmit regions (21a-21n) arranged in a row or in an area form the active surface of the transmit element (21).

## Revendications

1. Module optoélectronique d'émission comprenant au moins un élément (3) d'émission, au moins un élément (4) de contrôle et un dispositif (1) de couplage, qui a au moins un élément (6) optique de couplage et au moins un élément (7) réfléchissant, tant l'élément (7) réfléchissant que l'élément (6) de couplage du dispositif (1) de couplage étant disposés en face d'une partie (17) se trouvant sur un seul côté de composant de l'élément (3) d'émission d'une surface (8) active de l'élément (3) d'émission,
**caractérisé en ce que** le dispositif (1) de couplage est un corps (5) de base en une seule partie, sur lequel sont constitués directement l'élément (6) de couplage et l'élément (7) réfléchissant, l'élément (3) d'émission, l'élément (6) de couplage et l'élément (7) réfléchissant étant disposés les uns par rapport aux autres de façon à ce qu'au moins une partie de la lumière émise par l'élément (3) d'émission arrive sur l'élément (6) de couplage et sur l'élément (7) réfléchissant.

2. Module optoélectronique d'émission suivant la revendication 1, **caractérisé en ce que** le corps (5) de base est en un matériau transparent dans le domaine de longueur d'onde d'émission caractéristique de l'élément (3) d'émission.

3. Module optoélectronique d'émission suivant la revendication 1 ou 2, **caractérisé en ce qu'**au moins une partie (12) du rayonnement (10) émis par la partie (17) est déviée sur l'élément (4) de contrôle par réflexion sur l'élément (7) réfléchissant et une autre partie (11) du rayonnement (10) pénètre à travers l'élément (6) de couplage.

4. Module optoélectronique d'émission suivant l'une des revendications précédentes, **caractérisé en ce que** l'élément (7) réfléchissant est formé par au moins une partie métallisée du dispositif (1) de couplage.

5. Module optoélectronique d'émission suivant l'une des revendications précédentes, **caractérisé en ce qu'**au moins une cavité (29) métallisée par endroits du dispositif (20) de couplage sert d'élément réfléchissant.

6. Module optoélectronique d'émission suivant l'une des revendications précédentes, **caractérisé en ce que** le dispositif (20) de couplage est en matériau cristallin ou en verre.

7. Module optoélectronique d'émission suivant l'une des revendications précédentes, **caractérisé en ce que** le dispositif de couplage porte l'élément d'émission et l'élément de contrôle.

8. Module optoélectronique d'émission suivant l'une des revendications précédentes, **caractérisé en ce que** des parties (21a à 21n) d'émission actives du point de vue du rayonnement et disposées suivant une rangée ou suivant une surface forment la surface active de l'élément (21) d'émission.
